# EUROPÄISCHE PATENTSCHRIFT

(11) **EP 2 985 769 B1**
(45) Veröffentlichungstag und Bekanntmachung des Hinweises auf die Patenterteilung: **06.05.2020**
(21) Anmeldenummer: 15178398.2
(22) Anmeldetag: 27.07.2015
(51) Int. Cl.: H01F 6/02, G01R 33/3815, H01F 6/04, H01F 6/00

(54) **VERFAHREN ZUM LADEN EINER SUPRALEITFÄHIGEN MAGNETANORDNUNG MIT STROM**
METHOD FOR CHARGING A SUPERCONDUCTING MAGNET ASSEMBLY WITH POWER
PROCÉDÉ DE CHARGEMENT D'UN SYSTÈME MAGNÉTIQUE SUPRACONDUCTEUR À L'AIDE DE COURANT

(30) Priorität: 28.07.2014 DE 102014214796
(43) Veröffentlichungstag der Anmeldung: 17.02.2016
(73) Patentinhaber: Bruker Switzerland AG, 8117 Fällanden (CH)
(72) Erfinder: SCHAUWECKER, Robert, 8004 Zürich (CH); VONLANTHEN, Patrik, 8603 Schwerzenbach (CH)
(74) Vertreter: Kohler Schmid Möbus Patentanwälte

(56) Entgegenhaltungen:
- EP-A1- 0 730 284
- EP-A2- 1 757 950
- WO-A1-2007/107238
- DE-A1-102006 012 506
- DE-B3-102012 215 507
- JP-A- S58 111 305
- US-A1- 2006 066 429
- YANAGISAWA Y ET AL: "Effect of coil current sweep cycle and temperature change cycle on the screening current-induced magnetic field for YBCO-coated conductor coils", AIP CONFERENCE PROCEEDINGS AMERICAN INSTITUTE OF PHYSICS USA, Bd. 1434, 12. Juni 2012 (2012-06-12), Seiten 1373-1380, XP002752031, ISSN: 0094-243X, DOI: 10.1063/1.4707063

## Beschreibung

Die Erfindung betrifft ein Verfahren zum Laden einer in einer Kryostat-Vorrichtung zur Kühlung auf eine kryogene Betriebstemperatur angeordneten supraleitfähigen Magnetanordnung nach Anspruch 1.

Ein Verfahren zum Laden einer Kryostat-Vorrichtung ist auch bekannt aus der Publikation von Y. Yanagisawa et al., "Effect of coil current sweep cycle and temperature change cycle on the screening current-induced magnetic field for YBCO-coated conductor coils", AIP Conference Proceedings 1434, 1373 (2012) (=Referenz [9]).

### Hintergrund der Erfindung

Viele Magnetresonanzmethoden erfordern möglichst homogene statische Magnetfelder, beispielsweise, um im Fall einer spektroskopischen Methode eine hohe spektrale Auflösung oder, um im Fall einer bildgebenden Methode eine möglichst verzerrungsfreie und scharfe Abbildung zu erzielen. Zur Felderzeugung werden in der Regel supraleitende Magnetanordnungen eingesetzt.

Nach dem Laden einer solchen supraleitenden Magnetanordnung mit Bandleitern, insbesondere Hochtemperatur-Supraleitern (=HTS), können im Band teilweise persistente Abschirmströme fließen, welche die Feldstärke der Magnetanordnung verkleinern, oder zu Feldinhomogenitäten und Feldinstabilität führen. Dies ist etwa in Referenz [1] ausführlich beschrieben.

### Weiterer Stand der Technik

Es sind verschiedene Methoden und Anordnungen zur Auslöschung von Abschirmströmen am geladenen Magneten bekannt. Diese basieren auf folgenden Ansätzen: Durchlaufen von Feldzyklen, Hochfrequenz-Feldanregungen, Optimierung des Spulendesigns (Auslegung bezüglich Spulenform, Leitergeometrie, Stromtragfähigkeit des Supraleiters). Außerdem gibt es den Ansatz, die Abschirmströme nicht auszulöschen, sondern deren Effekt im Design der Magnetanordnung zu berücksichtigen und entsprechende Feldkorrektur-Möglichkeiten vorzusehen (z.B. Shimspulen). Die in der am Ende der Beschreibung angeführten Referenzliste zitierten Druckschriften zum Stand der Technik offenbaren folgende, als Ausgangspunkt für die vorliegende Erfindung grundlegende technische Aspekte:
[1] Magnetanordnung mit bandförmigen HTS-Wicklungen, z.B. für Hochfeld-NMR-(=Kernresonanz)-Anwendungen. Nach dem Laden der HTS-Bandleiter fließen teilweise persistente Abschirmströme, die die Feldstärke der Magnetanordnung verkleinern oder zu Feldinhomogenität und Feldinstabilität führen.
[2] Magnetanordnung mit HTS- und LTS-(=Tieftemperatur-Supraleiter)-Wicklungen, z.B. für Hochfeld-NMR-Anwendungen. Durch Überstromzyklen im HTS-Teil wird die Felddrift nach Erreichen des Endstroms minimiert.
[3] "longitudinal vortex shaking" durch ein Hochfrequenz-Magnetfeld in einer HTS-Magnetwicklung. Das Hochfrequenz-Feld steht senkrecht zum statischen Feld der HTS-Magnetwicklung und parallel zur Bandrichtung.
[4] "transversal vortex shaking" durch ein Hochfrequenz-Magnetfeld in einer HTS-Magnetwicklung. Das Hochfrequenz-Feld steht senkrecht zum statischen Feld der HTS-Magnetwicklung und quer zur Bandrichtung.
[5] "vortex shaking" durch ein Hochfrequenz-Magnetfeld in einer HTS-Magnetwicklung. Es werden Anordnungen von Kupferspulen zur Erzeugung des Hochfrequenzfeldes gezeigt.
[6] Multifilament-HTS-Bandleiter reduzieren die unerwünschten Feldbeiträge der Abschirmströme. Überstromzyklen zur Stabilisierung der Felddrift und Reduktion der Feldinhomogenität aufgrund von Abschirmströmen. Berechnung der AbschirmStromstärken in Abhängigkeit vom Formfaktor der HTS-Wicklung.
[7] Berechnung der Abschirmstromstärken in einer HTS-Wicklung in Abhängigkeit von der Spulenform, Leiterbreite und vom kritischen Strom des Supraleiters. Optimal ist ein schmaler Leiter, kleiner Spulendurchmesser, und großer Betriebsstrom im Verhältnis zum kritischen Strom.
[8] Messung des Effektes von Abschirmströmen in einer Anordnung von mehreren koaxialen HTS-Flachspulen bei einer Temperatur von 77 K im Eigenfeld und/oder in einem Hintergrundfeld. Verifikation einer Simulationsmethode zur Auslegung von Feldhomogenisierungsspulen (Shims) zur Kompensation der FeldInhomogenität aufgrund der Abschirmströme in der HTS-Wicklung insbesondere in einer Magnetanordnung mit HTS- und LTS-Wicklungen für Hochfeld-NMR-Anwendungen.
[9] Reduktion der Abschirmströme durch Feld- und Temperatur-Zyklen. Der Einfluss der Temperatur-Zyklen auf die Abschirmströme in einer HTS-Wicklung (YBCO) wird experimentell im Bereich von 77 bis 82 K untersucht und für Kryokühler-gekühlte Magnetanordnungen vorgeschlagen (siehe etwa Seite 1379: "This kind of coil temperature cycle is available for cryocooler cooled YBCO magnets.").
   Dieser -bereits eingangs zitierte- Stand der Technik nach Referenz [9] liegt dem gedanklichen Ausgangspunkt der vorliegenden Erfindung am nächsten:
   Nach dem Laden einer Magnetanordnung wird die Temperatur vorübergehend erhöht, wodurch die Abschirmströme zum Teil ausgelöscht werden. Dieser Zustand wird dann beim erneuten Abkühlen auf die Betriebstemperatur "eingefroren" .
   Allerdings ist diese Methode bisher nur bekannt für reine HTS-Magnetanordnungen. Wenn ein Teil der Magnetanordnung einen Tieftemperatur-Supraleiter umfasst, kann dieses Verfahren bisher nicht angewendet werden, weil damit der geladene Magnet über die Sprungtemperatur des Tieftemperatur-Supraleiters erwärmt würde, was unweigerlich einen "Quench" des Systems, also einen Zusammenbruch der supraleitenden Ströme in der Magnetanordnung zur Folge hätte.
[10] In einer Magnetanordnung mit HTS- und LTS-Wicklungen für Hochfeld-NMR-Anwendungen wird je ein supraleitender Strompfad mit nur HTS- und mit nur LTS-Wicklungen gebildet, indem je ein supraleitender Schalter über diesen Wicklungen geschlossen wird. Diese elektrische Schaltung ermöglicht verschiedene Verfahren zur Stabilisierung des Magnetfeldes der supraleitend kurzgeschlossenen HTS- und LTS-Wicklungen im Persistentbetrieb, selbst dann, wenn die HTS-Wicklungen einen kleinen elektrischen Rest-Widerstand beispielsweise auf Grund einer nicht perfekt ausgeführten supraleitenden HTS-Leiter-Verbindung aufweisen.

### Aufgabe der Erfindung

Der vorliegenden Erfindung liegt demgegenüber die Aufgabe zugrunde, ein Verfahren der eingangs definierten Art vorzustellen, in welchem beim Laden von supraleitenden Magnetanordnungen mit kombinierten Magnetwicklungen aus supraleitenden Materialen von deutlich unterschiedlichen Sprungtemperaturen, insbesondere bei Tieftemperatur-Supraleiter-(LTS)- und Hochtemperatur-Supraleiter-(HTS)-Systemen, eine Auslöschung oder Vermeidung von Abschirmströmen durch eine Temperierung der Magnetanordnung sowie ein anschließendes Einfrieren des Zustandes mit reduzierten Abschirmströmen beim Abkühlen auf die Betriebstemperatur erreicht wird, ohne dabei Ströme in den Magnetwicklungen mit dem Material von tieferer Sprungtemperatur (insbesondere LTS-Material) zu löschen.

### Kurze Beschreibung der Erfindung

Diese Aufgabe wird auf überraschend einfache Art und Weise sowie mit ohne Weiteres zur Verfügung stehenden technischen Mitteln gelöst durch eine Modifikation eines Verfahrens mit den eingangs genannten Merkmalen, die dadurch gekennzeichnet ist, dass die Magnetanordnung eine zweite Magnetwicklung aus einem zweiten Supraleitermaterial mit einer zweiten Sprungtemperatur oberhalb der Betriebstemperatur und mindestens 15 K unterhalb der ersten Sprungtemperatur umfasst, wobei die erste Magnetwicklung zumindest teilweise aus HTS-Material und die zweite Magnetwicklung zumindest teilweise aus LTS-Material aufgebaut ist, und dass das Ladeverfahren eine Erregung eines zweiten Betriebsstromes mindestens in einem Teil der zweiten Magnetwicklung spätestens nach dem Abkühlen der Magnetanordnung auf die Betriebstemperatur umfasst, wobei die zweite Magnetwicklung mit dem zweiten Betriebsstrom ein zweites Betriebsmagnetfeld im Volumen der ersten Magnetwicklung erzeugt.

### Wirkungsweise der Erfindung und weitere Vorteile gegenüber dem Stand der Technik

Abschirmströme im bandförmigen Supraleiter und deren unerwünschten Auswirkungen auf die Stärke, Homogenität und Stabilität des Magnetfeldes werden bereits beim Abkühlen und Laden der Magnetanordnung verhindert, so dass auf nachträgliche Maßnahmen zur Reduktion oder Stabilisierung der Abschirmströme mindestens teilweise verzichtet werden kann. Dadurch wird sowohl der apparative als auch der Verfahrensaufwand reduziert, und es werden technische Risiken (z.B.: Quenchen der Magnetanordnung) vermieden. Außerdem gelingt eine wirkungsvolle Unterdrückung von Abschirmströmen besser und effektiver durch ihre Verhinderung zum Vornherein als durch ihre Unterdrückung im Nachhinein. Die gründlichste Unterdrückung von Abschirmströmen kann von einer Kombination des erfindungsgemäßen Verfahrens mit bekannten Methoden zur nachträglichen Unterdrückung von Abschirmströmen erwartet werden. Verfahren zur Verhinderung von Abschirmströmen bereits beim Abkühlen und Laden einer Magnetanordnung sind bisher nur für reine HTS-Magnetanordnungen bekannt. Sie können nun dank dem erfindungsgemäßen Verfahren beispielsweise auch auf Magnetanordnungen mit Wicklungen aus Hoch- und Tieftemperatur-Supraleitern (HTS + LTS) angewendet werden, welche insbesondere für Höchstfeld-Anwendungen in NMR-Verfahren von Bedeutung sind.

### Bevorzugte Ausführungsformen der Erfindung

Ganz besonders bevorzugt ist eine Klasse von Ausführungsformen des erfindungsgemäßen Verfahrens, bei denen die Magnetanordnung auf mindestens eine weitere Vorlauftemperatur zwischen der ersten Sprungtemperatur und der Betriebstemperatur temperiert und danach ein weiterer Vorlaufstrom mindestens in einem Teil der ersten Magnetwicklung erregt wird. Diese Ausführungsformen des Verfahrens tragen dem Umstand Rechnung, dass die supraleitende Stromtragfähigkeit des Bandleiters in der ersten Magnetwicklung mit abnehmender Temperatur zunimmt. Beispielsweise kann bei einer weiteren Vorlauftemperatur ein höherer Vorlaufstrom erregt werden als bei einer höheren ersten Vorlauftemperatur, wodurch Abschirmströme im Bandleiter noch besser unterdrückt werden können.

Vorteilhafte Weiterbildungen dieser Ausführungsformen sind dadurch gekennzeichnet, dass die Intervalle zwischen den Vorlauftemperaturen und/oder Vorlaufstrom-Erregungsschritten derart fein gewählt werden, dass ein kontinuierlicher Temperier- und Abkühlvorgang der Magnetanordnung auf die Betriebstemperatur und/oder eine kontinuierliche Abfolge von Vorlaufstrom-Erregungsschritten in der ersten Magnetwicklung erreicht werden. Auf diese Weise können die Vorlaufströme beispielsweise bereits während dem Abkühlvorgang der Magnetanordnung erregt werden, ohne dass der Abkühlvorgang bei bestimmten diskreten Vorlauftemperaturen angehalten werden müsste.

Besonders bevorzugte Varianten dieser Klasse von Ausführungsformen zeichnen sich dadurch aus, dass das Temperieren der supraleitenden Magnetanordnung auf eine erste oder eine weitere Vorlauftemperatur durch Befüllung eines Behälters der Kryostatanordnung mit Flüssigstickstoff oder durch den Betrieb eines Kryokühlers erfolgt. Magnetanordnungen, welche durch ein Flüssiggas-Bad gekühlt werden, werden typischerweise mit FlüssigStickstoff vorgekühlt, dessen Siedetemperatur unterhalb der Sprungtemperatur gewisser Hochtemperatur-Supraleiter liegt. Bei dieser Temperatur kann also bereits ein Vorlaufstrom erregt werden. Bei Kühlung durch einen Kryokühler ist das erfindungsgemäße Verfahren besonders vorteilhaft, weil die Temperatur der Magnetanordnung durch die Steuerung der Kryokühler-Leistung eingestellt werden kann, was die gezielte Temperierung auf einer Vorlauftemperatur erleichtert.

Bei weiteren vorteilhaften Verfahrensvarianten erfolgt das Abkühlen der supraleitenden Magnetanordnung auf die Betriebstemperatur durch Befüllung eines Behälters der Kryostatanordnung mit Flüssighelium oder durch den Betrieb eines Kryokühlers. Weil sich der Abkühlvorgang einer durch ein Flüssiggas-Bad gekühlten Magnetanordnung durch Einleiten von Flüssig-Helium in einen Behälter der Kryostatanordnung über mehrere Stunden erstrecken kann, können in der ersten Magnetwicklung während dieser Phase Vorlaufströme erregt werden, sobald die Temperatur der Magnetanordnung die erste Sprungtemperatur unterschritten hat. Bei Kühlung durch einen Kryokühler ist das erfindungsgemäße Verfahren besonders vorteilhaft, weil die Temperatur der Magnetanordnung durch die Steuerung der Kryokühler-Leistung eingestellt werden kann, was die gezielte Temperierung auf einer Vorlauftemperatur erleichtert.

Bei weiteren vorteilhaften Ausführungsformen des erfindungsgemäßen Verfahrens beträgt ein erster und/oder ein weiterer erregter Vorlaufstrom in der ersten Magnetwicklung auf einer ersten und/oder einer weiteren Vorlauftemperatur mindestens 50%, bevorzugt mindestens 70%, insbesondere mindestens 90% der supraleitenden Stromtragfähigkeit mindestens in einem Teil der ersten Magnetwicklung bei dieser Temperatur und im eigenen Magnetfeld. Wenn die supraleitende Stromtragfähigkeit in der ersten Magnetwicklung durch den erregten Vorlaufstrom weitgehend ausgeschöpft wird, können nur noch minimale Abschirmströme fließen. Beispielsweise kann eine Vorlauftemperatur so gewählt werden, dass die supraleitende Stromtragfähigkeit mindestens in einem Teil der ersten Magnetwicklung nur geringfügig (insbesondere wenige Prozent bis einige zehn Prozent) über dem ersten Betriebsstrom liegt, so dass als Vorlaufstrom der volle erste Betriebsstrom erregt werden kann, ohne dass sich aufgrund einer großen Stromtragfähigkeits-Reserve in der ersten Magnetwicklung bedeutende Abschirmströme aufbauen könnten. Bei dieser Wahl einer Vorlauftemperatur ist darauf zu achten, dass die supraleitende Stromtragfähigkeit im berücksichtigten Teil der ersten Magnetwicklung nicht nur von der Temperatur abhängt, sondern auch vom Magnetfeld, welches die erste Magnetwicklung mit dem Vorlaufstrom im Volumen der Magnetwicklung erzeugt.

Vorteilhaft sind auch Ausführungsformen des erfindungsgemäßen Verfahrens, bei denen ein erster und/oder ein weiterer erregter Vorlaufstrom und der erste Betriebsstrom eine zeitlich monoton ansteigende Folge von Stromstärken in der ersten Magnetwicklung bilden. So kann die Stromerregungskurve in der ersten Magnetwicklung beispielsweise während dem Abkühlvorgang der Magnetanordnung der monoton ansteigenden Kurve der supraleitenden Stromtragfähigkeit der ersten Magnetwicklung bei abnehmender Temperatur in geringer Entfernung folgen, bis der erste Betriebsstrom erreicht ist. So werden Abschirmströme aufgrund einer großen Stromtragfähigkeits-Reserve in der ersten Magnetwicklung fortlaufend verhindert.

Bei einer weiteren bevorzugten Verfahrensvariante bilden eine erste und mindestens eine weitere Vorlauftemperatur und die Betriebstemperatur eine zeitlich monoton fallende Folge von Temperaturen. So kann beispielsweise der Abkühlvorgang der Magnetanordnung auf die Betriebstemperatur zur Temperierung auf die Vorlauftemperatur(en) genutzt werden.

Bevorzugt sind auch Verfahrensvarianten, bei welchen ein erster und/oder mindestens ein weiterer erregter Vorlaufstrom und der erste Betriebsstrom eine zeitliche Folge von Stromstärken in der ersten Magnetwicklung bilden, deren Werte gegen das Ende der Folge hin abnehmen, so dass insbesondere der erste Betriebsstrom kleiner ist als ein erster erregter Vorlaufstrom und/oder kleiner als mindestens ein weiterer erregter Vorlaufstrom. Beim Absenken des Stromes in der ersten Magnetwicklung auf den ersten Betriebsstrom wird auch das Magnetfeld, welches die erste Magnetwicklung mit ihrem Strom in ihrem Volumen erzeugt, reduziert. Damit kann beispielsweise ein Feldbeitrag, welchen die zweite Magnetwicklung nach Erregung des zweiten Betriebsstromes im Volumen der ersten Magnetwicklung erzeugt, kompensiert werden.

Ganz besonders bevorzugt sind auch Ausführungsformen des erfindungsgemäßen Verfahrens, bei denen die Magnetanordnung nach dem Laden in einem Dauerzustand mit gleichbleibender Betriebstemperatur und mit gleichbleibendem erstem und zweitem Betriebsstrom betrieben wird, insbesondere als Teil einer Anordnung für Magnetresonanz-Verfahren. Solche Magnetanordnungen werden während ihrer Lebensdauer nur wenige Male abgekühlt und geladen, so dass sich ein Lade-Verfahren zur Verhinderung von dauerhaft fließenden Abschirmströmen über eine besonders lange Zeitspanne hin auszahlt. Außerdem werden solche Magnetanordnungen häufig für Anwendungen eingesetzt, welche hinsichtlich Feldhomogenität und Feldstabilität in einem Arbeitsvolumen besonders anspruchsvoll sind.

Nicht Teil der beanspruchten Erfindung ist eine Vorrichtung, die sich dadurch auszeichnet, dass die supraleitfähige Magnetanordnung derart ausgestaltet ist, dass das erste Betriebsmagnetfeld mindestens an einem Ort innerhalb der ersten Magnetwicklung eine Komponente senkrecht zur Band-Ebene aufweist, welche mindestens doppelt so stark ist wie die Komponente senkrecht zur Band-Ebene des zweiten Betriebsmagnetfeldes an diesem Ort. Abschirmströme werden insbesondere durch die Magnetfeldkomponente senkrecht zur Bandebene erzeugt. Beispielsweise weist das Eigenfeld einer solenoidförmigen ersten Magnetwicklung aus einem Hochtemperatur-Supraleiterband an den beiden Spulenrändern eine Feldkomponente senkrecht zur Bandebene auf. Solche Spulen können innerhalb einer koaxial um sie herum angeordneten zweiten Magnetwicklung aus Tieftemperatur-Supraleitern betrieben werden. Wenn die zweite Magnetwicklung in Richtung der gemeinsamen Achse wesentlich länger ausgelegt wird als die erste, bleibt ihr Beitrag zur senkrechten Feldkomponente im Volumen der ersten Magnetwicklung unbedeutend. Für eine solche Magnetanordnung ist das erfindungsgemäße Ladeverfahren besonders vorteilhaft, weil nach Durchlaufen der Abfolge von Temperierungs- und Vorlaufstrom-Erregungsschritten in der ersten Magnetwicklung durch das Erregen des zweiten Betriebsstromes in der zweiten Magnetwicklung keine bedeutenden neuen Abschirmströme aufgebaut werden können. Magnetanordnungen dieser Art haben darüber hinaus den Vorteil, dass die gewickelte Menge an Hochtemperatur-Supraleiterband minimiert werden kann, was die Herstellungskosten reduziert.

Nicht Teil der beanspruchten Erfindung ist auch eine Vorrichtung zur Durchführung des erfindungsgemäßen Verfahrens, bei welcher die supraleitfähige Magnetanordnung derart ausgestaltet ist, dass das zweite Betriebsmagnetfeld mindestens an einem Ort innerhalb der ersten Magnetwicklung eine Komponente senkrecht zur Band-Ebene aufweist, welche mindestens 5% der Feldstärke des zweiten Betriebsfeldes an diesem Ort beträgt, wobei das Verfahren zum Laden der Magnetanordnung sich dadurch auszeichnet, dass die erste Magnetwicklung an diesem Ort nach dem Temperieren auf eine erste oder eine weitere Vorlauftemperatur und dem Erregen eines ersten oder weiteren Vorlaufstromes ein Magnetfeld erzeugt, dessen Komponente senkrecht zur Band-Ebene der Summe aus der Komponente senkrecht zur Bandebene des ersten Betriebsmagnetfeldes und aus mindestens der Hälfte der Komponente senkrecht zur Bandebene des zweiten Betriebsmagnetfeldes an diesem Ort entspricht. Wenn es sich aufgrund von Randbedingungen für die Auslegung der Magnetanordnung (beispielweise Platzbeschränkungen) nicht vermeiden lässt, dass im Betriebszustand die zweite Magnetwicklung im Volumen der ersten Magnetwicklung eine bedeutende Feldkomponente senkrecht zur Bandebene erzeugt, dann werden durch diese Ausführungsform des erfindungsgemäßen Verfahrens Abschirmströme im Bandleiter aufgrund des Erregens des zweiten Betriebsstromes in der zweiten Magnetwicklung vermieden, weil die zusätzliche Feldkomponente senkrecht zur Bandebene der zweiten Magnetwicklung durch einer Reduktion der Feldkomponente senkrecht zur Bandebene der ersten Magnetwicklung kompensiert wird.

Nicht Teil der beanspruchten Erfindung ist eine Klasse von Ausführungsformen einer Vorrichtung zur Durchführung des erfindungsgemäßen Verfahrens, die dadurch gekennzeichnet ist, dass die erste Magnetwicklung zumindest teilweise aus HTS-Material und die zweite Magnetwicklung zumindest teilweise aus LTS-Material aufgebaut ist. Von diesen beiden Supraleiter-Klassen sind Leiter in ausreichender Länge und Qualität für Magnetanwendungen verfügbar. Magnetanordnungen mit Hochtemperatur-Supraleitern können stärkere Magnetfelder erzeugen als reine Tieftemperatur-Supraleiter-Magnete. Eine Magnetanordnung mit einer Tieftemperatur-Supraleiter-Wicklung und einer Hochtemperatur-Einsatz-Spule erzeugt ebenfalls stärkere Felder als ein reiner Tieftemperatur-Supraleiter-Magnet, ist aber kostengünstiger als ein reiner Hochtemperatur-Supraleiter-Magnet. Weil Hochtemperatur-Supraleiter als Bandleiter ausgeführt sein können, ist ein Verfahren zur Verhinderung von Abschirmströmen in solchen Magnetanordnungen besonders vorteilhaft. Solche Verfahren sind besonders wirksam, wenn sie eine Temperierung der mindestens teilweise stromtragenden Magnetanordnung deutlich über die Betriebstemperatur hinaus umfassen. Dank dem erfindungsgemäßen Verfahren ist der Temperier-Bereich für gemischte Hoch-/Tieftemperatur-Supraleiter Magnetanordnungen nicht durch die Sprungtemperatur des Tieftemperatur-Supraleiters begrenzt, wodurch eine wirksame Auslöschung von Abschirmströmen im Hochtemperatur-Supraleiter durch Temperierung der Magnetanordnung erst möglich wird.

Vorteilhafte nicht beanspruchte Weiterbildungen dieser Ausführungsformen sind dadurch gekennzeichnet, dass die erste Magnetwicklung einen Bandleiter mit einem HTS in Form einer Dünnschicht, insbesondere vom Typ ReBCO (Re = "rare earth", z.B. Yttrium), und die zweite Magnetwicklung NbTi und/oder Nb₃Sn umfasst. Diese Supraleiter-Klassen sind für Magnetanwendungen ausgereift und in ausreichenden Längen verfügbar. Die Leitergeometrie von ReBCO-Bändern begünstigt Abschirmströme, weshalb ein Ladeverfahren zu deren Verhinderung in Magnetanordnungen mit diesen Leitern besonders vorteilhaft ist.

Nicht beansprucht sind auch Weiterbildungen, bei welchen die erste Magnetwicklung mehrere koaxial gestapelte Flachspulen oder eine Solenoid-Spule umfasst. Dies sind die beiden geläufigsten Formen von Magnet-Wicklungen aus Bandleitern. Beide erzeugen im Volumen der Wicklung zu den beiden Spulenenden hin ein Magnetfeld mit einer bedeutenden Komponente senkrecht zur Bandebene, was den Aufbau von Abschirmströmen begünstigt. Ein Ladeverfahren zur Verhinderung von Abschirmströmen ist in solchen Magnetanordnungen daher besonders vorteilhaft.

Bei alternativen oder ergänzenden nicht beanspruchten Weiterbildungen verfügen die erste und zweite Magnetwicklung über insgesamt mindestens drei Stromanschlüsse, wovon mindestens ein erster nur die erste Magnetwicklung und mindestens ein anderer nur die zweite Magnetwicklung und mindestens ein weiterer nur die erste Magnetwicklung oder die erste und zweite Magnetwicklung zusammen kontaktiert. Die Erregung unterschiedlicher Ströme in der ersten und zweiten Magnetwicklung während der Anwendung des erfindungsgemäßen Verfahrens bedingt, dass diese über separate Stromanschlüsse verfügen. Weil Stromzuleitungen zu einer supraleitenden Magnetanordnung einen unerwünschten Wärmeeintrag leisten, soll die Anzahl Zuleitungen minimiert werden. Für zwei supraleitende Magnetwicklungen mit unterschiedlichen Strömen braucht es mindestens je eine Zuleitung pro Wicklung und eine gemeinsame Rückleitung.

Besonders bevorzugte nicht beanspruchte Weiterbildungen schließlich zeichnen sich dadurch aus, dass die erste und zweite Magnetwicklung eine Serienschaltung bilden, so dass insbesondere der erste und der zweite Betriebsstrom gleich stark sind. In einer solchen Magnetanordnung können die erste und zweite Magnetwicklung zusammen mit einem gemeinsamen supraleitenden Schalter überbrückt und nach dem Laden persistent betrieben werden. Wenn die Magnetanordnung im Betriebszustand an eine Stromquelle angeschlossen bleibt, sind nur noch zwei Zuleitungen stromtragend. In beiden Fällen kann somit der Wärmeeintrag in die Kryostatanordnung über die Stromzuleitungen minimiert werden.

In der Praxis wird das erfindungsgemäße Verfahren bei Apparaturen Anwendung finden, bei welchen die supraleitfähige Magnetanordnung Teil einer Magnetresonanz-Vorrichtung, insbesondere eines NMR-Spektrometers, eines MRI-Scanners, eines EPR-Geräts oder eines lonen-Zyklotron-Resonanz-Geräts ist. Diese Vorrichtungen werden alle auf eine Weise verwendet, bei der ein räumlich sehr homogenes und zeitlich sehr stabiles Magnetfeld in einem Arbeitsvolumen Voraussetzung für ein optimales Messresultat ist. Weiter sind bei diesen Vorrichtungen immer auch die Einstellmöglichkeiten der Magnetfeldhomogenität mittels Shims und die Kompensationsmöglichkeiten von Felddriften durch die verfügbare Hardware limitiert. Beim Betrieb dieser Vorrichtungen profitiert man in besonderem Maße vom erfindungsgemäßen Verfahren, welches bestmögliche Homogenität und Stabilität des Magnetfeldes unter Berücksichtigung dieser Hardware-Limiten erreicht.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig.1a: eine schematische Schnittbild-Darstellung einer Magnetanordnung zur Durchführung des erfindungsgemäßen Verfahrens, welche in einer Kryostat-Vorrichtung zur Kühlung auf eine kryogene Betriebstemperatur mittels Befüllung eines Behälters mit einer kryogenen Flüssigkeit angeordnet ist;
- Fig.1b: den zeitlichen Verlauf der Temperatur der erfindungsgemäßen Magnetanordnung und der in ihren Magnetwicklungen fließenden Ströme bei Anwendung des erfindungsgemäßen Ladeverfahrens;
- Fig.2: den zeitlichen Verlauf der Temperatur der erfindungsgemäßen Magnetanordnung und der in ihren Magnetwicklungen fließenden Ströme bei Anwendung des erfindungsgemäßen Ladeverfahrens mit mehreren Temperier- und Stromerregungsschritten;
- Fig.3: den zeitlichen Verlauf der Temperatur der erfindungsgemäßen Magnetanordnung und der in ihren Magnetwicklungen fließenden Ströme bei Anwendung des erfindungsgemäßen Ladeverfahrens mit einem kontinuierlichen Temperier- und Stromverlauf;
- Fig.4: den zeitlichen Verlauf der Temperatur der erfindungsgemäßen Magnetanordnung und der in ihren Magnetwicklungen fließenden Ströme bei Anwendung des erfindungsgemäßen Ladeverfahrens mit gleichen Betriebsströmen in der ersten und zweiten Wicklung;
- Fig.5: den zeitlichen Verlauf der Temperatur der erfindungsgemäßen Magnetanordnung und der in ihren Magnetwicklungen fließenden Ströme bei Anwendung des erfindungsgemäßen Ladeverfahrens mit einer ersten Vorlauftemperatur und einem ersten Vorlaufstrom von ca. 90% der supraleitenden Stromtragfähigkeit in einem Teilvolumen der ersten Magnetwicklung bei dieser Temperatur und im Eigenfeld der ersten Magnetwicklung bei diesem Strom;
- Fig.6: eine schematische Schnittbild-Darstellung einer Magnetanordnung zur Durchführung des erfindungsgemäßen Verfahrens, welche in einer Kryostat-Vorrichtung zur Kühlung auf eine kryogene Betriebstemperatur mittels eines Kryokühlers angeordnet ist;
- Fig.7a: eine schematische Schnittbild-Darstellung einer ersten Magnetwicklung einer Magnetanordnung zur Durchführung des erfindungsgemäßen Verfahrens in Form einer Solenoid-Spule;
- Fig.7b: eine schematische Schnittbild-Darstellung einer ersten Magnetwicklung einer Magnetanordnung zur Durchführung des erfindungsgemäßen Verfahrens in Form mehrerer koaxial gestapelter Flachspulen;
- Fig.8: das elektrische Schaltschema einer Magnetanordnung zur Durchführung des erfindungsgemäßen Verfahrens mit der minimal erforderlichen Anzahl von drei Stromanschlüssen zur Erregung unterschiedlicher Ströme in der ersten und zweiten Magnetwicklung und mit zwei Stromquellen.
- Fig.9a: eine schematische Schnittbild-Darstellung einer Magnetanordnung zur Durchführung des erfindungsgemäßen Verfahrens sowie die Vektoren der Betriebsmagnetfelder der ersten und zweiten Magnetwicklung an einem Ort innerhalb der ersten Magnetwicklung sowie deren Vektorkomponenten senkrecht zur Bandebene des Bandleiters in der ersten Magnetwicklung, mit einem unbedeutenden Beitrag der zweiten Magnetwicklung zur gesamten Feldkomponente senkrecht zur Bandebene an diesem Ort;
- Fig.9b: eine schematische Schnittbild-Darstellung einer Magnetanordnung zur Durchführung des erfindungsgemäßen Verfahrens sowie die Vektoren der Betriebsmagnetfelder der ersten und zweiten Magnetwicklung an einem Ort innerhalb der ersten Magnetwicklung sowie deren Vektorkomponenten senkrecht zur Bandebene des Bandleiters in der ersten Magnetwicklung, mit einem bedeutenden Beitrag der zweiten Magnetwicklung zur gesamten Feldkomponente senkrecht zur Bandebene an diesem Ort;

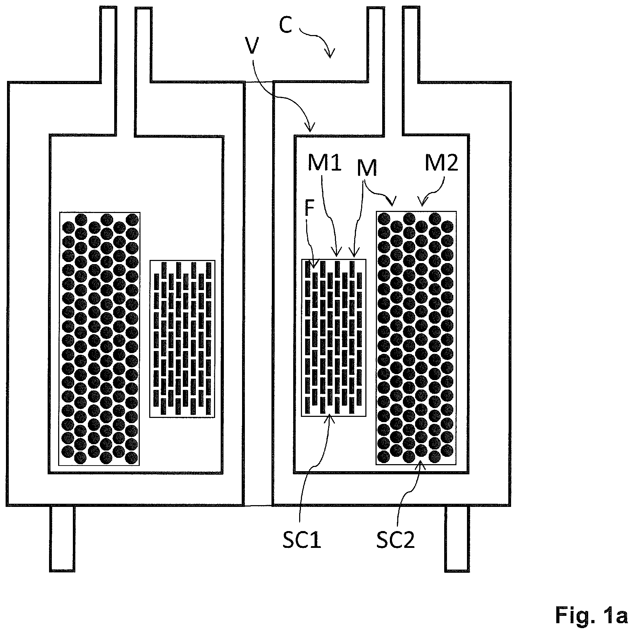

Die **Figur 1a** zeigt eine schematische Schnittbild-Darstellung einer supraleitfähigen Magnetanordnung M zur Durchführung des erfindungsgemäßen Verfahrens. Sie umfasst eine erste Magnetwicklung M1 mit einem Bandleiter F aus einem ersten Supraleitermaterial SC1 und einer ersten Sprungtemperatur Tc1 und eine zweite Magnetwicklung M2 aus einem zweiten Supraleitermaterial SC2 mit einer zweiten Sprungtemperatur Tc2 mindestens 15 K unterhalb der ersten Sprungtemperatur Tc1.

Die Magnetanordnung M ist in einer Kryostat-Vorrichtung C zur Kühlung auf eine kryogene Betriebstemperatur T0 angeordnet. Die Kühlung der Magnetanordnung M auf die Betriebstemperatur T0 oder die Temperierung der Magnetanordnung M auf eine Vorlauftemperatur T1, T2 kann durch Befüllung eines Behälters V mit einer kryogenen Flüssigkeit, beispielsweise FlüssigStickstoff oder Flüssig-Helium, erfolgen.

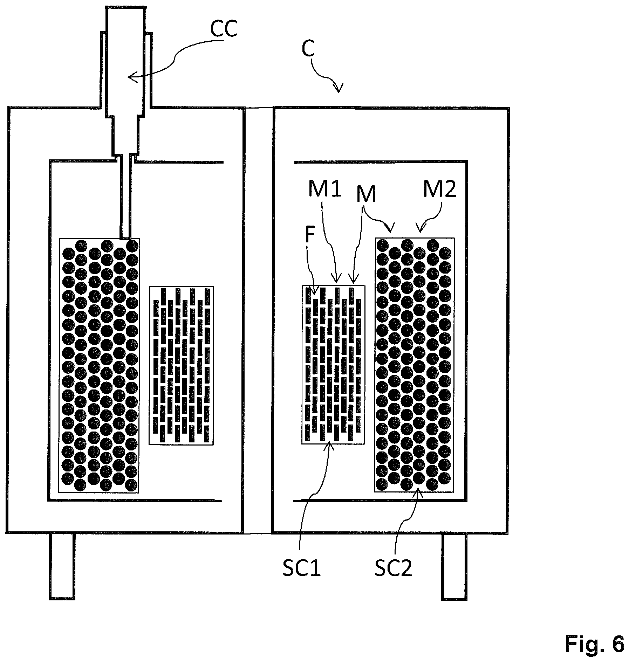

Alternativ dazu zeigt die **Figur 6** eine Kryostatvorrichtung C mit einem Kryokühler CC zur Kühlung der Magnetanordnung M.

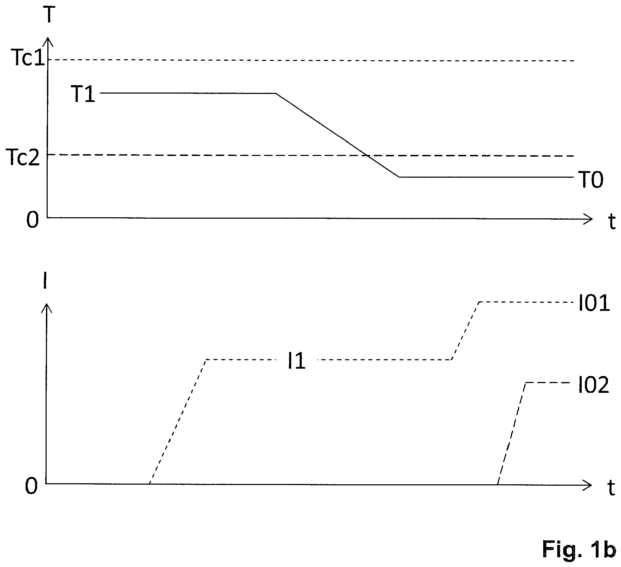

Die **Figur 1b** zeigt den zeitlichen Verlauf der Temperatur T der Magnetanordnung M und der in ihrer ersten und zweiten Magnetwicklung M1 und M2 erregten Ströme I bei Anwendung des erfindungsgemäßen Ladeverfahrens. Der zeitliche Temperaturverlauf und der Stromverlauf sind über einer gemeinsamen Zeitachse t synchronisiert dargestellt. Der zeitliche Verlauf des Stromes in der ersten Magnetwicklung M1 folgt der fein gestrichelten Linie im I(t)-Diagramm, der Strom in der zweiten Magnetwicklung M2 folgt der grob gestrichelten Linie. Das Verfahren umfasst eine Temperierung der Magnetanordnung M auf eine erste Vorlauftemperatur T1 zwischen der ersten Sprungtemperatur Tc1 und der Betriebstemperatur T0, die Erregung eines ersten Vorlaufstromes I1 nach Erreichen der ersten Vorlauftemperatur T1 mindestens in einem Teil der ersten Magnetwicklung M1, das Abkühlen der Magnetanordnung M auf die Betriebstemperatur T0 und die Erregung eines ersten und zweiten Betriebsstromes I01 und I02 mindestens in je einem Teil der ersten und zweiten Magnetwicklung M1 und M2.

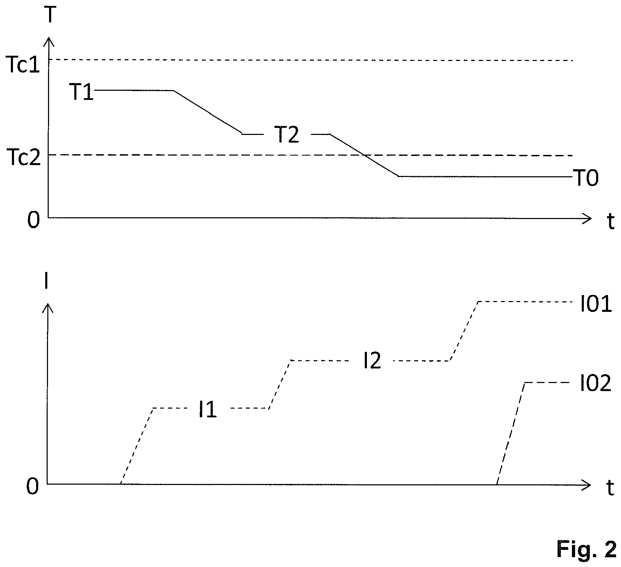

Die **Figur 2** zeigt eine Ausführungsform des erfindungsgemäßen Verfahrens, bei welcher die Magnetanordnung M zusätzlich auf eine weitere Vorlauftemperatur T2 zwischen der ersten Sprungtemperatur Tc1 und der Betriebstemperatur T0 temperiert wird, wonach ein weiterer Vorlaufstrom I2 mindestens in einem Teil der ersten Magnetwicklung M1 erregt wird.

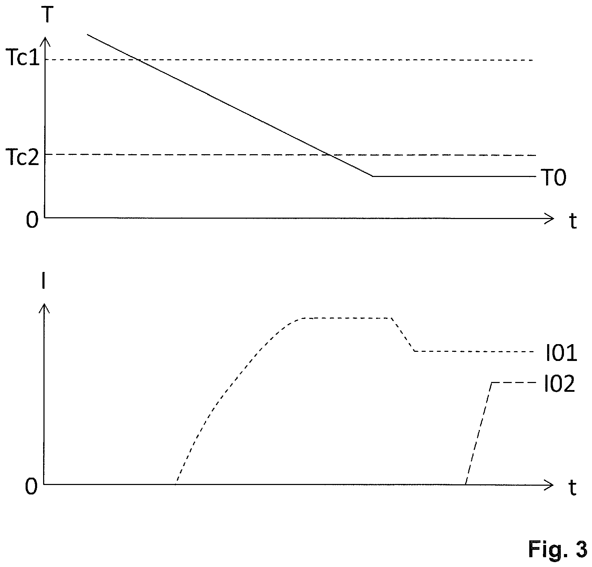

Die **Figur 3** zeigt eine Ausführungsform des erfindungsgemäßen Verfahrens mit einer Verfeinerung der Intervalle zwischen den Vorlauftemperaturen und Vorlaufstrom-Erregungsschritten bis hin zum Grenzfall eines kontinuierlichen Abkühlvorgangs der Magnetanordnung M auf die Betriebstemperatur T0 und einer gleichzeitigen kontinuierlichen Abfolge von Vorlaufstrom-Erregungsschritten in der ersten Magnetwicklung M1. Die Kühlung der Magnetanordnung M auf die Betriebstemperatur T0 dauert sowohl bei Einleitung einer kryogenen Flüssigkeit in einen Behälter V der Kryostat-Vorrichtung C als auch mit dem Betrieb eines Kryokühlers CC typischerweise mehrere Stunden. Die Erregung von Vorlaufströmen in der ersten Magnetwicklung M1 kann dagegen wesentlich schneller erfolgen, so dass eine Sequenz oder kontinuierliche Folge von Vorlaufströmen während dem Abkühlvorgang durchlaufen werden kann, ohne dass dieser zeitweise angehalten werden müsste.

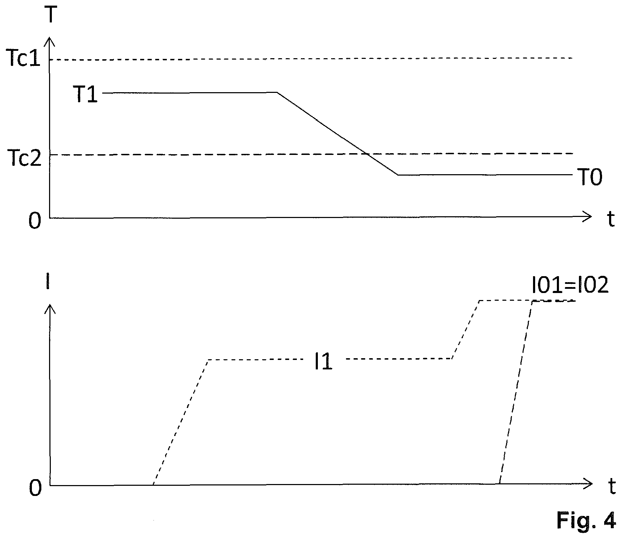

Die **Figur 4** zeigt eine Ausführungsform des erfindungsgemäßen Verfahrens, bei welchem die Betriebsströme I01 und I02 in der ersten und zweiten Magnetwicklung M1 und M2 gleich sind.

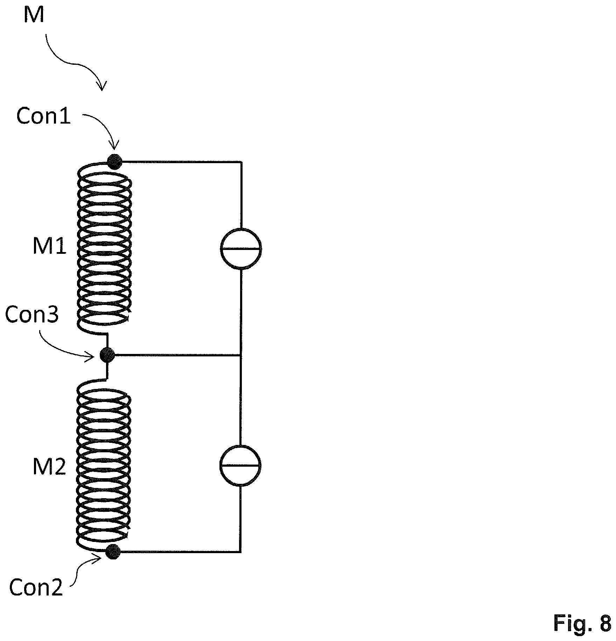

Wenn die erste und zweite Magnetwicklung M1 und M2 darüber hinaus eine Serienschaltung bilden, wie in **Figur 8** gezeigt, dann können diese nach Erregen des Betriebsstromes I01 = I02 durch einen gemeinsamen supraleitenden Schalter überbrückt werden, so dass die Zuleitungen zur Stromspeisung stromlos geschaltet oder sogar entfernt werden können. Wenn dagegen der Betriebsstrom dauerhaft über die Stromspeisung fließt, kann unter der Bedingung gleicher Betriebsströme I01 = I02 auf eine der beiden für das Ladeverfahren benötigten Stromspeisungen verzichtet werden, und eine der drei für das Ladeverfahren benötigten Stromzuleitungen wird stromlos.

All diese Ausführungsformen reduzieren den Wärmeeintrag in die Kryostat-Vorrichtung C. Dies ist vor allem für Magnetanordnungen M von Vorteil, welche nach dem Abkühl- und Ladevorgang in einem Dauerzustand mit gleichbleibender Betriebstemperatur T0 und gleichbleibendem erstem und zweitem Betriebsstrom I01 und I02 betrieben werden, also beispielsweise für Magnetanordnungen M, welche in Magnetresonanz-Anwendungen eingesetzt werden.

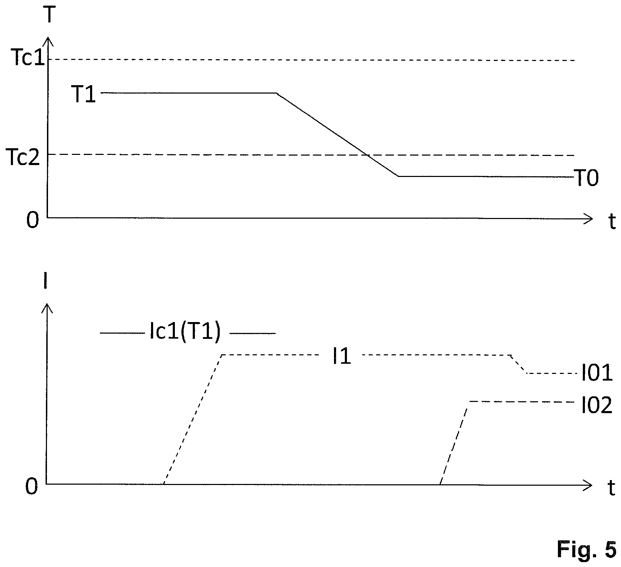

Die **Figur 5** zeigt eine Ausführungsform des erfindungsgemäßen Verfahrens, bei welcher eine erste Vorlauftemperatur T1 nach einem Kriterium festgelegt wird, welches im Folgenden erläutert wird. In der ersten Magnetwicklung M1 liegt der erste Betriebsstrom I01 in der ganzen Wicklung notwendigerweise unter der supraleitenden Stromtragfähigkeit Ic1 des Bandleiters F bei der Betriebstemperatur T0. Weil die supraleitende Stromtragfähigkeit des Bandleiters F nicht nur von der Temperatur sondern auch vom Magnetfeld am Ort des Leiters abhängt, nimmt das Verhältnis von Betriebsstrom I01 zur supraleitenden Stromtragfähigkeit Ic1im Volumen der ersten Magnetwicklung M1 unterschiedliche Werte kleiner eins an. Unerwünscht starke Abschirmströme fließen im Bandleiter F insbesondere dort, wo dieses Verhältnis sehr viel kleiner als eins ist (beispielsweise < 0.5) und das Magnetfeld eine bedeutende Komponente senkrecht zur Bandebene aufweist.

Wenn in der ersten Magnetwicklung M1 im Betriebszustand diese Bedingungen mindestens an einem Ort erfüllt sind, dann wird eine erste Vorlauftemperatur T1 so gewählt, dass der erste Vorlaufstrom I1 die supraleitende Stromtragfähigkeit Ic1 des Bandleiters F an diesem kritischen Ort maximal ausschöpft (zu mindestens 50%, mit Vorteil bis zu mindestens 90%), unter Berücksichtigung der Abhängigkeit der supraleitenden Stromtragfähigkeit Ic1 von der Vorlauftemperatur T1 und vom eigenen Magnetfeld der ersten Magnetwicklung M1 mit dem Vorlaufstrom I1 am kritischen Ort. Zusätzlich muss die Vorlauftemperatur T1 tief genug gewählt werden, dass der Vorlaufstrom I1 im ganzen Volumen der Magnetwicklung M1 unterhalb der supraleitenden Stromtragfähigkeit Ic1 des Bandleiters F liegt.

Es ist vorteilhaft, mindestens die Stärke des ersten Betriebsstromes I01 als Vorlaufstrom I1 zu erregen. Wenn nämlich nach dem Abkühlen der Magnetanordnung M auf die Betriebstemperatur T0 der Strom in der ersten Magnetwicklung M1, und damit auch ihr Feldbeitrag am kritischen Ort, nochmals erhöht würde, würden wegen der höheren supraleitenden Stromtragfähigkeit Ic1 des Bandleiters F bei der Betriebstemperatur T0 am kritischen Ort viel stärkere Abschirmströme fließen, als wenn der volle erste Betriebsstrom I01 bereits auf einer möglichst hohen Vorlauftemperatur T1 erregt worden wäre.

Falls die zweite Magnetwicklung M2 im Betriebszustand am kritischen Ort einen Feldbeitrag mit einer bedeutenden Komponente senkrecht zur Bandebene des Leiters beisteuert und damit Abschirmströme am kritischen Ort erzeugt, dann wird eine tiefere erste Vorlauftemperatur T1 und ein höherer erster Vorlaufstrom I1 als im vorherigen Beispiel gewählt. Dann kann nach Erregen des zweiten Betriebsstromes I02 in der zweiten Magnetwicklung M2 der Strom in der ersten Magnetwicklung M1 von der Stärke I1 auf den Betriebswert I01 abgesenkt werden, und somit reduziert sich auch der Feldbeitrag der ersten Magnetwicklung M1 am kritischen Ort, wodurch bestenfalls der Feldbeitrag der zweiten Magnetwicklung M2 an diesem Ort kompensiert wird (insbesondere die Feldkomponente senkrecht zur Bandebene), und die Abschirmströme aufgrund der Erregung des zweiten Betriebsstromes I02 in der zweiten Magnetwicklung M2 wieder abgebaut werden. Diese Ausführungsform ist in **Figur 5** gezeigt.

Die in den **Figuren 1a** bis **5** gezeigten Ausführungsformen des erfindungsgemäßen Verfahrens zeigen Vorlauftemperaturen T1, T2 zwischen der ersten und zweiten Sprungtemperatur Tc1, Tc2. Es sind aber auch Vorlauftemperaturen Unterhalb Tc2 möglich.

Die in den **Figuren 1a** bis **5** gezeigten Ausführungsformen des erfindungsgemäßen Verfahrens zeigen insbesondere:
- eine zeitlich monoton ansteigende Abfolge von Stromstärken aus einem ersten und mindestens einem weiteren Vorlaufstrom I1, I2 und dem ersten Betriebsstrom I01,
- eine zeitliche Abfolge von Stromstärken aus einem ersten und mindestens einem weiteren Vorlaufstrom I1, I2 und dem ersten Betriebsstrom 101, deren Werte gegen das Ende der Abfolge hin abnehmen, so dass insbesondere der erste Betriebsstrom I01 kleiner ist als ein erster erregter Vorlaufstrom I1 und/oder kleiner als mindestens ein weiterer erregter Vorlaufstrom I2,
- eine zeitlich monoton fallende Abfolge von Temperaturen aus einer ersten und mindestens einer weiteren Vorlauftemperatur T1, T2 und der Betriebstemperatur T0.

Diese Ausführungsformen von Sequenzen von Stromerregungen in der ersten Magnetwicklung M1 und Temperaturen der Magnetanordnung M sind exemplarisch und nicht als abschließende Aufzählung von Ausführungsformen zu verstehen. Beispielsweise sind auch Sequenzen mit ansteigenden Vorlauftemperaturen T1, T2 möglich.

Die **Figur 6** zeigt eine schematische Schnittbild-Darstellung einer supraleitfähigen Magnetanordnung M zur Durchführung des erfindungsgemäßen Verfahrens. Sie umfasst eine erste Magnetwicklung M1 mit einem Bandleiter F aus einem ersten Supraleitermaterial SC1 und einer ersten Sprungtemperatur Tc1 und eine zweite Magnetwicklung M2 aus einem zweiten Supraleitermaterial SC2 mit einer zweiten Sprungtemperatur Tc2 mindestens 15 K unterhalb der ersten Sprungtemperatur Tc1.

Die Magnetanordnung M ist in einer Kryostat-Vorrichtung C zur Kühlung auf eine kryogene Betriebstemperatur T0 angeordnet. Die Kühlung der Magnetanordnung M auf die Betriebstemperatur T0 oder die Temperierung der Magnetanordnung M auf eine Vorlauftemperatur T1, T2 erfolgt durch den Betrieb eines Kryokühlers CC.

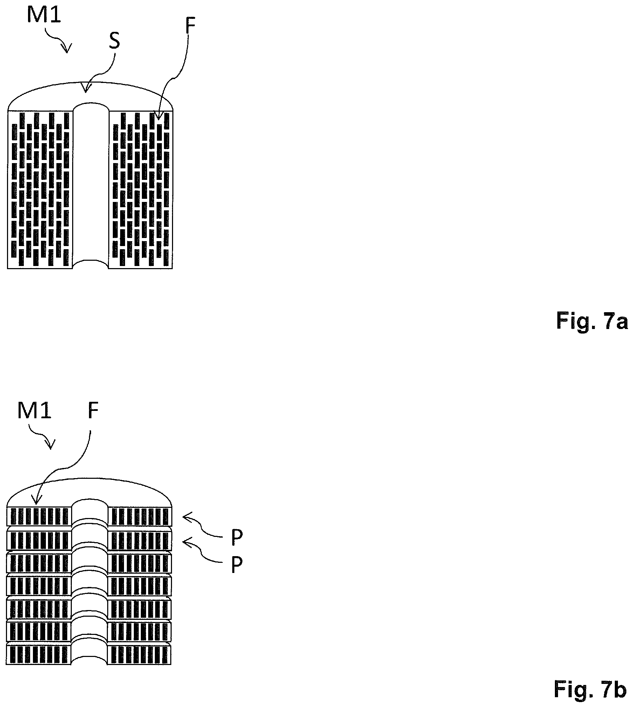

Die **Figur 7a** zeigt eine schematische Schnittbild-Darstellung einer ersten Magnetwicklung M1, in welcher der Bandleiter F in Form einer Solenoid-Spule gewickelt ist. Alternativ dazu können mit dem Bandleiter F mehrere Flachspulen P gewickelt und koaxial gestapelt werden, wie in **Figur 7b** gezeigt wird.

Die **Figur 8** zeigt ein elektrisches Schaltbild einer Magnetanordnung M mit einer ersten und zweiten Magnetwicklung M1 und M2 und mit mindestens drei Stromanschlüssen Con1, Con2 und Con3, an welchen die Zuleitungen von den Stromquellen zu den Magnetwicklungen M1, M2 zur Erregung der Vorlauf- und Betriebsströme kontaktiert sind. In einer solchen Magnetanordnung M können die mindestens zeitweise unterschiedlichen Ströme in der ersten und zweiten Magnetwicklung M1 und M2 unabhängig voneinander erregt werden.

Wenn der erste und zweite Betriebsstrom I01 und I02 gleich stark sind, wird die Stromzuleitung am Anschlusspunkt Con3 im Betriebszustand der Magnetanordnung M stromlos.

Wenn die erste und zweite Magnetwicklung M1 und M2 im Betriebszustand nach Erregen der Betriebsströme I01 und I02 zusammen oder einzeln mit supraleitenden Schaltern überbrückt werden, können alle Stromzuleitungen stromlos geschaltet werden, indem die Stromquellen auf null gefahren werden. Sowohl Zuleitungen und Stromquellen können dann entfernt werden. Dieser sogenannte "persistent mode" ist vor allem dann vorteilhaft, wenn die Magnetanordnung M dauerhaft in Betrieb bleibt. So kann der Wärmeeintrag in die Kryostat-Vorrichtung C minimiert werden. Darüber hinaus ist dieser besonders störungsarme Betriebszustand für empfindliche Anwendungen der Magnetanordnung M beispielsweise für Magnetresonanz-Verfahren besonders vorteilhaft.

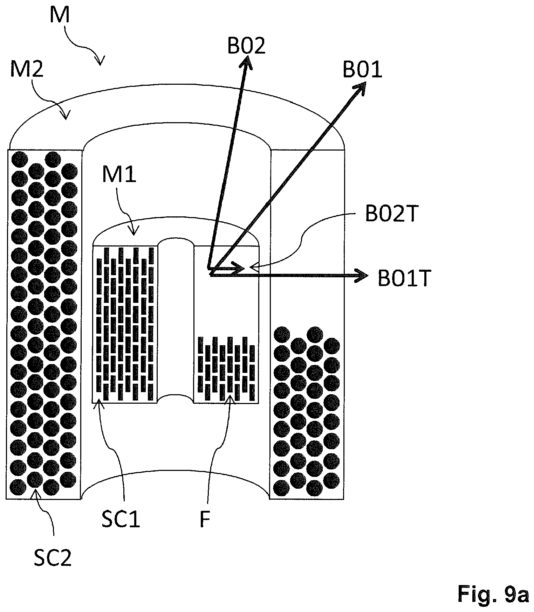

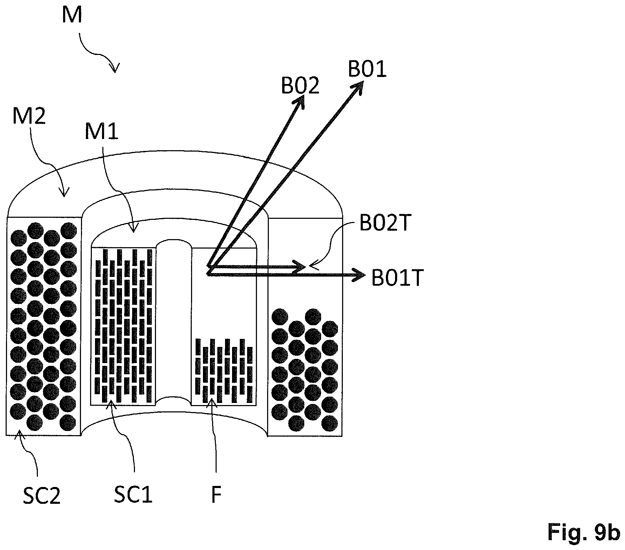

Die **Figuren 9a** und **9b** zeigen schematische Schnittbild-Darstellungen einer supraleitfähigen Magnetanordnung M mit einer ersten Magnetwicklung M1 mit einem Bandleiter F aus einem ersten Supraleitermaterial SC1 und mit einer zweiten Magnetwicklung M2 aus einem zweiten Supraleitermaterial SC2.

Außerdem sind an einem Ort in der Schnittfläche durch die erste Magnetwicklung M1 die Vektoren des ersten und zweiten Betriebsmagnetfeldes B01 und B02 sowie deren Komponenten B01T und B02T senkrecht zur Bandebene eingezeichnet. Die Betriebsmagnetfeld-Vektoren sind durch die Wicklungs- und Leitergeometrie und durch die Stärke des ersten und zweiten Betriebsstromes I01 und I02 gegeben.

In einer zylindersymmetrischen Magnetanordnung M liegen die Magnetfeldvektoren an einem Raumpunkt immer in der Ebene, welche durch den Raumpunkt und die Symmetrieachse definiert wird, also beispielsweise in der Schnittebene der Darstellung in den **Figuren 9a** und **9b**. Unerwünschte supraleitende Abschirmströme im Bandleiter F der ersten Magnetwicklung M1 werden hauptsächlich durch die Magnetfeldkomponenten senkrecht zur Bandebene erregt.

Für das erfindungsgemäße Ladeverfahren ist es von Bedeutung, ob im Volumen der ersten Magnetwicklung die zur Bandebene senkrechte Komponente B01T des ersten Betriebsmagnetfeldes B01 überwiegt, oder ob auch das zweite Betriebsmagnetfeld B02 zumindest lokal eine bedeutende Komponente B02T senkrecht zur Bandebene aufweist. Der erste Fall liegt insbesondere dann vor, wenn B01T mindestens doppelt so groß ist wie B02T (**Figur 9a**). Der zweite Fall liegt insbesondere dann vor, wenn B02T größer ist als 5% von B02 (**Figuren 9a** und **9b**).

Im ersten Fall rühren die Abschirmströme hauptsächlich von der zur Bandebene senkrecht stehenden Komponente des Eigenfeldes der ersten Magnetwicklung M1 her. Das erfindungsgemäße Verfahren nutzt die Eigenschaften einer solchen Anordnung, indem es die Schritte zur Unterdrückung der Abschirmströme vorzugsweise auf die erste Magnetwicklung M1 ausrichtet und nach dem Laden der zweiten Magnetwicklung M2 keine weiteren Verfahrensschritte mehr vorsieht. Den ersten Fall trifft man beispielsweise in Magnetanordnungen M mit einer kurzen, kompakten HTS-Einsatz-Spule als erster Magnetwicklung M1 und einer langen LTS-Außenspule als zweiter Magnetwicklung M2 an. Die meisten Magnetanordnungen M mit HTS- und LTS-Wicklungen weisen diese Form auf, weil so einerseits die Kosten für den teuren HTS-Leiter gesenkt werden und andererseits die supraleitende Stromtragfähigkeit Ic1 im Bandleiter F erhöht wird (diese wird durch die Feldkomponente senkrecht zur Bandebene limitiert).

Im zweiten Fall trägt auch die zweite Magnetwicklung M2 zur Erregung von Abschirmströmen mindestens an einem Ort in der ersten Magnetwicklung M1 bei. Das erfindungsgemäße Verfahren umfasst dann mit Vorteil die Erregung eines ersten oder weiteren Vorlaufstromes I1, I2 derart, dass das Eigenfeld der ersten Magnetwicklung M1 mit dem Strom I1 oder I2 an diesem Ort eine Komponente senkrecht zur Band-Ebene aufweist, welche der Summe aus der Komponente B01T senkrecht zur Bandebene des ersten Betriebsmagnetfeldes B01 und aus mindestens der Hälfte der Komponente B02T senkrecht zur Bandebene des zweiten Betriebsmagnetfeldes B02 an diesem Ort entspricht.

Wenn die Feldkomponente B02T senkrecht zur Bandebene der zweiten Magnetwicklung M2 an einem Ort nicht vernachlässigbar ist, kann diese demnach durch Überladen der ersten Magnetwicklung M1 "simuliert" werden, bevor die zweite Magnetwicklung M2 tatsächlich geladen wird. In diesem überladenen Zustand der ersten Magnetwicklung M1 werden dann die Abschirmströme durch das Temperier-Verfahren unterdrückt. Nach dem Abkühlen auf die Betriebstemperatur T0 und vor oder während oder nach dem Laden der zweiten Magnetwicklung M2 wird die erste Magnetwicklung M1 teilweise entladen, so dass die Gesamt-Feldkomponente senkrecht zum Band an diesem Ort ungefähr konstant gehalten wird. Dadurch können keine neuen Abschirmströme aufgebaut werden.

Bei supraleitfähigen Magnetanordnungen M mit Magnetwicklungen mit mindestens zwei verschiedenen Supraleitermaterialien mit unterschiedlichen Sprungtemperaturen Tc1, Tc2 handelt es sich typischerweise um Anordnungen mit einer ersten Magnetwicklung M1 aus einem Hochtemperatur-Supraleiter (HTS) und einer zweiten Magnetwicklung M2 aus einem oder verschiedenen Tieftemperatur-Supraleiter(n) (LTS). Die gebräuchlichsten LTS sind die Verbindungen NbTi und Nb3Sn.

Das erfindungsgemäße Verfahren ist insbesondere dann vorteilhaft, wenn es sich beim HTS um den Typ ReBCO (Re = "rare earth", z.B. Yttrium) handelt. HTS-Leiter dieser Klasse werden für technische Anwendungen typischerweise als dünne Schicht auf einen bandförmigen Träger aufgebracht. Wenn an einem solchen Bandleiter F ein Magnetfeld senkrecht zur Bandebene angelegt wird, erzeugen die erregten Abschirmströme besonders starke unerwünschte Magnetfeldbeiträge, beispielsweise im Arbeitsbereich einer Magnetanordnung M mit einer ersten Magnetwicklung M1 aus diesem Leiter.

Darüber hinaus werden erste Magnetwicklungen M1 mit einem ReBCO-Bandleiter F in einer LTS/HTS Magnetanordnung M häufig mit einem ersten Betriebsstrom I01 deutlich unter der supraleitenden Stromtragfähigkeit Ic1 in der ersten Magnetwicklung M1 betrieben, was zu besonders starken Abschirmströmen führt. ReBCO-Bandleiter F haben aber auch eine Eigenschaft, welche sie für die Anwendung des erfindungsgemäßen Verfahrens zur Vermeidung von Abschirmströmen prädestiniert: die Abhängigkeit ihrer supraleitenden Stromtragfähigkeit vom Magnetfeld ist stark anisotrop. Ein Magnetfeld senkrecht zur Bandebene reduziert die supraleitende Stromtragfähigkeit weit stärker als ein Magnetfeld parallel zur Bandebene.

Dies erlaubt eine besonders wirksame Anwendung der Ausführungsform des erfindungsgemäßen Verfahrens von **Figur 5**: Wenn die Abschirmströme im Betriebszustand der Magnetanordnung M beispielsweise hauptsächlich durch das Eigenfeld der ersten Magnetwicklung M1 erregt werden, soll ein erster Vorlaufstrom I1 von der Stärke des ersten Betriebsstromes I01 erregt werden. Die erste Vorlauftemperatur T1 kann dann erfindungsgemäß so festgelegt werden, dass die supraleitende Stromtragfähigkeit Ic1(T1) am Ort mit der stärksten Feldkomponente senkrecht zur Bandebene in der ersten Magnetwicklung M1 nur leicht höher ist als der Vorlaufstrom I1 (=I01). Dies ist möglich, weil die supraleitende Stromtragfähigkeit Ic1 an diesem Ort innerhalb der ersten Magnetwicklung M1 aufgrund der Anisotropie des Bandleiters typischerweise am niedrigsten ist. So können an diesem besonders kritischen Ort Abschirmströme weitgehend unterdrückt werden.

Nach dem Abkühlen der Magnetanordnung M auf die Betriebstemperatur T0 wird in diesem Ausführungsbeispiel der Strom und damit das Eigenfeld der ersten Magnetwicklung M1 nicht mehr geändert, so dass das niedrige Niveau der Abschirmströme erhalten bleibt.

Bei der Erregung des zweiten Betriebsstromes I02 in der zweiten Magnetwicklung M2 entstehen ebenfalls keine wesentlichen Abschirmströme wegen der in diesem Beispiel angenommenen unbedeutenden senkrecht zur Bandebene stehenden Komponente B02T des zweiten Betriebsfeldes B02.

Andernfalls würde ein erster Vorlaufstrom I1 größer als der erste Betriebsstrom I01 erregt (bei einer tieferen ersten Vorlauftemperatur T1 verglichen mit dem vorherigen Beispiel), derart dass die senkrecht zur Bandebene stehende Komponente des Eigenfeldes der ersten Magnetwicklung M1 mit dem ersten Vorlaufstrom I1 vorzugsweise der Summe B01T + B02T der senkrecht zur Bandebene stehenden Komponenten des ersten und zweiten Betriebsfeldes B01, B02 entspricht, mindestens aber der Summe B01T + 0.5 x B02T aus der senkrecht zur Bandebene stehenden Komponente B01T des ersten Betriebsfeldes B01 und aus mindestens der Hälfte der senkrecht zur Bandebene stehenden Komponente B02T des zweiten Betriebsfeldes B02.

### Haupt-Anwend ungsgebiete

Das erfindungsgemäße Verfahren kann bei supraleitfähigen Magnetanordnungen in sämtlichen bekannten Magnetresonanz-Vorrichtungen angewendet werden, wie zum Beispiel MRI Scanner, NMR Spektrometer oder EPR Geräten, aber auch bei der hochauflösenden Massenspektroskopie.

Besonders bevorzugt kann das erfindungsgemäße Verfahren zum Homogenisieren oder Stabilisieren des statischen Magnetfeldes in dem Arbeitsvolumen einer Magnetresonanz-Vorrichtung eingesetzt werden, wobei die Magnetresonanz-Vorrichtung ein NMR-Spektrometer, ein MRI-Scanner, ein EPR-Gerät oder ein lonen-Zyklotron-Resonanz-Gerät sein kann.

### Bezugszeichenliste:

- C: Kryostat-Vorrichtung
- V: Behälter der Kryostatanordnung
- M: Supraleitfähige Magnetanordnung
- F: Bandleiter
- P: Flachspule
- S: Solenoidspule
- CC: Kryokühler
- M1: erste Magnetwicklung
- M2: zweite Magnetwicklung
- SC1: erstes Supraleitermaterial
- SC2: zweites Supraleitermaterial
- t: Zeitachse
- T: Temperatur der Magnetanordnung
- T0: Betriebstemperatur
- T1: erste Vorlauftemperatur
- T2: weitere Vorlauftemperatur
- Tc1: erste Sprungtemperatur
- Tc2: zweite Sprungtemperatur
- I: Strom
- I01: erster Betriebsstrom
- I02: zweiter Betriebsstrom
- I1: erster Vorlaufstrom
- I2: weiterer Vorlaufstrom
- Ic1: supraleitende Stromtragfähigkeit in der ersten Magnetwicklung
- B01: erstes Betriebsmagnetfeld
- B02: zweites Betriebsmagnetfeld
- B01T: Komponente des ersten Betriebsmagnetfeldes senkrecht zur Bandebene
- B02T: Komponente des zweiten Betriebsmagnetfeldes senkrecht zur Bandebene
- Con1: Erster Stromanschluss
- Con2: Anderer Stromanschluss
- Con3: Weiterer Stromanschluss

### Referenzliste

[1] Naoyuki Amemiya and Ken Akachi, "Magnetic field generated by shielding current in high Tc superconducting coils for NMR magnets", Supercond. Sci. Technol. 21 (2008)
[2] Y. Yanagisawa et al, "Effect of current sweep reversal on the magnetic field stability for a Bi-2223 superconducting solenoid", Physica C 469, 1996 (2009)
[3] G. P. Mikitik and E. H. Brandt, "Theory of the longitudinal vortex-shaking effect in superconducting strips" Physical Review B 67, 104511 (2003)
[4] E. H. Brandt and G. P. Mikitik, "Why an ac magnetic field shifts the irreversibility line in type-II superconductors", Physical Review Letters 89, 27002 (2002)
[5] K. Kajikawa and K. Funaki, "Reduction of Magnetization in Windings Composed of HTS Tapes", IEEE Transactions on Applied Superconductivity 22, 4400404 (2012)
[6] Y. Yanagisawa et al., "Effect of YBCO-Coil Shape on the Screening Current-Induced Magnetic Field Intensity", IEEE Transactions on Applied Superconductivity 20, 744 (2010)
[7] Y. Yanagisawa et al. "Magnitude of the Screening Field for YBCO Coils", IEEE Transactions on Applied Superconductivity 21, 1640 (2011)
[8] Ahn et al., "Spatial and Temporal Variations of a Screening Current Induced Magnetic Field in a Double-Pancake HTS Insert of an LTS/HTS NMR Magnet"; IEEE Transactions on Applied Superconductivity 19, 2269 (2009)
[9] Y. Yanagisawa et al., "Effect of coil current sweep cycle and temperature change cycle on the screening current-induced magnetic field for YBCO-coated conductor coils", AIP Conference Proceedings 1434, 1373 (2012)
[10] US 2006/0066429 A1

## Patentansprüche

1. Verfahren zum Laden einer in einer Kryostat-Vorrichtung (C) zur Kühlung auf eine kryogene Betriebstemperatur (T0) angeordneten supraleitfähigen Magnetanordnung (M), wobei das Verfahren folgende Schritte umfasst:
(a) Bereitstellen einer supraleitfähigen Magnetanordnung (M), welche aufweist:
• eine einen Bandleiter (F) umfassende erste Magnetwicklung (M1) mit einem ersten Supraleitermaterial (SC1) und einer ersten Sprungtemperatur (Tc1) oberhalb der Betriebstemperatur (T0); und
• eine zweite Magnetwicklung (M2) aus einem zweiten Supraleitermaterial (SC2) mit einer zweiten Sprungtemperatur (Tc2) oberhalb der Betriebstemperatur (T0) und mindestens 15 K unterhalb der ersten Sprungtemperatur (Tc1),
wobei die erste Magnetwicklung (M1) zumindest teilweise aus HTS-Material und die zweite Magnetwicklung (M2) zumindest teilweise aus LTS-Material aufgebaut ist,
(b) Temperierung der Magnetanordnung (M) auf eine erste Vorlauftemperatur (T1) zwischen der ersten Sprungtemperatur (Tc1) und der Betriebstemperatur (T0),
(c) Erregung eines ersten Vorlaufstromes (I1) nach Erreichen der ersten Vorlauftemperatur (T1) mindestens in einem Teil der ersten Magnetwicklung (M1),
(d) Abkühlen der Magnetanordnung (M) auf die Betriebstemperatur (T0)
(e) Erregung eines ersten Betriebsstromes (I01) spätestens nach Erreichen der Betriebstemperatur (T0) mindestens in einem Teil der ersten Magnetwicklung (M1),
wobei die erste Magnetwicklung (M1) mit dem ersten Betriebsstrom (I01) ein erstes Betriebsmagnetfeld (B01) im Volumen der ersten Magnetwicklung (M1) erzeugt,
(f) Erregung eines zweiten Betriebsstromes (I02) mindestens in einem Teil der zweiten Magnetwicklung (M2) spätestens nach dem Abkühlen der Magnetanordnung (M) auf die Betriebstemperatur (T0),
- wobei die zweite Magnetwicklung (M2) mit dem zweiten Betriebsstrom (I02) ein zweites Betriebsmagnetfeld (B02) im Volumen der ersten Magnetwicklung (M1) erzeugt.

2. Verfahren nach Anspruch 1, wobei die Magnetanordnung (M) auf mindestens eine weitere Vorlauftemperatur (T2) zwischen der ersten Sprungtemperatur (Tc1) und der Betriebstemperatur (T0) temperiert und danach ein weiterer Vorlaufstrom (12) mindestens in einem Teil der ersten Magnetwicklung (M1) erregt wird.

3. Verfahren nach Anspruch 2, wobei die Intervalle zwischen den Vorlauftemperaturen (T1, T2) und/oder Vorlaufstrom-Erregungsschritten derart fein gewählt werden, dass ein kontinuierlicher Temperier- und Abkühlvorgang der Magnetanordnung (M) auf die Betriebstemperatur (T0) und/oder eine kontinuierliche Abfolge von Vorlaufstrom-Erregungsschritten in der ersten Magnetwicklung (M1) erreicht werden.

4. Verfahren nach einem der vorhergehenden Ansprüche, wobei das Temperieren der supraleitenden Magnetanordnung (M) bei der ersten oder der weiteren Vorlauftemperatur (T1, T2) durch Befüllung eines Behälters (V) der Kryostatanordnung mit Flüssigstickstoff oder durch den Betrieb eines Kryokühlers (CC) erfolgt.

5. Verfahren nach einem der Ansprüche 1 bis 3, wobei das Abkühlen der supraleitenden Magnetanordnung (M) auf die Betriebstemperatur (T0) durch Befüllung eines Behälters (V) der Kryostatanordnung mit Flüssighelium oder durch den Betrieb eines Kryokühlers (CC) erfolgt.

6. Verfahren nach einem der Ansprüche 2 bis 5, wobei der erste und/oder der weitere erregte Vorlaufstrom (I1, I2) und der erste Betriebsstrom (I01) eine zeitlich monoton ansteigende Folge von Stromstärken in der ersten Magnetwicklung (M1) bilden.

7. Verfahren nach einem der Ansprüche 2 bis 6, wobei die erste und mindesten die weitere Vorlauftemperatur (T1, T2) und die Betriebstemperatur (T0) eine zeitlich monoton fallende Folge von Temperaturen bilden.

8. Verfahren nach einem der Ansprüche 2 bis 5, wobei der erste und/oder mindesten der weitere erregte Vorlaufstrom (I1, I2) und der erste Betriebsstrom (I01) eine zeitliche Folge von Stromstärken in der ersten Magnetwicklung (M1) bilden, deren Werte gegen das Ende der Folge hin abnehmen, so dass insbesondere der erste Betriebsstrom (I01) kleiner ist als der erste erregte Vorlaufstrom (I1) und/oder kleiner als mindestens der weitere erregte Vorlaufstrom (I2).

9. Verfahren nach einem der vorhergehenden Ansprüche, wobei die Magnetanordnung (M) nach dem Laden in einem Dauerzustand mit gleichbleibender Betriebstemperatur (T0) und mit gleichbleibendem erstem und zweitem Betriebsstrom (I01, I02) betrieben wird, insbesondere als Teil einer Anordnung für Magnetresonanz-Verfahren.

## Claims

1. A method for charging a superconducting magnet arrangement (M) which is disposed in a cryostat device (C) for cooling to a cryogenic operating temperature (T0), the method comprising the following steps:
(a) providing a superconducting magnet arrangement (M) comprising:
a first magnet winding (M1) having a tape conductor (F) with a first superconductor material (SC1) and a first transition temperature (Tc1) above the operating temperature (T0); and
a second magnet winding (M2) composed of a second superconductor material (SC2) with a second transition temperature (Tc2) above the operating temperature (T0) and at least 15 K below the first transition temperature (Tc1),
wherein first magnet winding (M1) is wound at least partially with HTS material and the second magnet winding (M2) is wound at least partially with LTS material,
b) temperature-controlling the magnet arrangement (M) to a first pre-operating temperature (T1) between the first transition temperature (Tc1) and the operating temperature (T0);
c) exciting a first pre-operating current (I1) after the first pre-operating temperature (T1) is reached at least in a part of the first magnet winding (M1);
d) cooling the magnet arrangement (M) to the operating temperature (T0);
e) exciting a first operating current (I01) at the latest after the operating temperature (T0) is reached at least in a part of the first magnet winding (M1),
wherein the first magnet winding (M1) with the first operating current (101) generates a first operating magnetic field (B01) in the volume of the first magnet winding (M1);
f) exciting a second operating current (102) at least in a part of the second magnet winding (M2) at the latest after cooling of the magnet arrangement (M) to the operating temperature (T0), wherein with the second operating current (102) the second magnet winding (M2) generates a second operating magnetic field (B02) in the volume of the first magnet winding (M1).

2. The method of claim 1, wherein the magnet arrangement (M) is temperature-controlled to at least a further pre-operating temperature (T2) between the first transition temperature (Tc1) and the operating temperature (T0) and then a further pre-operating current (12) is excited at least in a part of the first magnet winding (M1).

3. The method of claim 2, wherein the intervals between the pre-operating temperatures (T1, T2) and/or pre-operating current excitation stages are selected so finely that a continuous temperature-controlling and cooling procedure of the magnet arrangement (M) to the operating temperature (T0) and/or a continuous sequence of pre-operating current excitation stages in the first magnet winding (M1) are achieved.

4. The method of any one of the preceding claims, wherein temperature-controlling of the superconducting magnet arrangement (M) at the first or the further pre-operating temperature (T1, T2) is achieved by filling of a container (V) of the cryostat arrangement with liquid nitrogen or by the operation of a cryocooler (CC).

5. The method of any one of claims 1 to 3, wherein cooling of the superconducting magnet arrangement (M) to the operating temperature (T0) is achieved by filling of a container (V) of the cryostat arrangement with liquid helium or by the operation of a cryocooler (CC).

6. The method of any one of the claims 2 to 5, wherein the first and/or the further excited pre-operating current (I1, I2) and the first operating current (I01) form a chronologically monotonically increasing sequence of current intensities in the first magnet winding (M1).

7. The method of any one of the claims 2 to 6, wherein the first and at least the further pre-operating temperature (T1, T2) and the operating temperature (T0) form a chronologically monotonically decreasing sequence of temperatures.

8. The method of any one of the claims 2 to 5, wherein the first and/or at least the further excited pre-operating current (I1, I2) and the first operating current (I01) form a chronological sequence of current intensities in the first magnet winding (M1), values of which decrease towards the end of the sequence, such that in particular the first operating current (101) is smaller than the first excited pre-operating current (I1) and/or smaller than at least the further excited pre-operating current (12).

9. The method of any one of the preceding claims, wherein the magnet arrangement (M) is operated after charging in a steady state with constant operating temperature (T0) and with constant first and second operating current (101, 102), in particular as part of an arrangement for magnetic resonance processes.

## Revendications

1. Procédé de charge d'un agencement d'aimants supraconducteurs (M) disposé dans un dispositif cryogénique (C) pour le refroidissement à une température de fonctionnement cryogénique (T0), le procédé comprenant les étapes suivantes :
(a) mise à disposition d'un agencement d'aimants supraconducteurs (M) présentant:
• un premier enroulement magnétique (M1) comprenant un conducteur en ruban (F) avec un premier matériau supraconducteur (SC1) et une première température de transition (Tc1) supérieure à la température de fonctionnement (T0) ; et
• un second enroulement magnétique (M2) constitué d'un second matériau supraconducteur (SC2) ayant une seconde température de transition (Tc2) supérieure à la température de fonctionnement (T0) et inférieure d'au moins 15 K à la première température de transition (Tc1),
le premier enroulement magnétique (M1) étant constitué au moins partiellement d'un matériau HTS et le second enroulement magnétique (M2) au moins partiellement d'un matériau LTS,
(b) mise en température de l'agencement d'aimants (M) à une première température de départ (T1) entre la première température de transition (Tc1) et la température de fonctionnement (T0),
(c) excitation d'un premier courant de départ (I1) après avoir atteint la première température de départ (T1) au moins dans une partie du premier enroulement magnétique (M1),
(d) refroidissement de l'agencement d'aimants (M) à la température de fonctionnement (T0),
(e) excitation d'un premier courant de fonctionnement (I01) au plus tard après avoir atteint la température de fonctionnement (T0) au moins dans une partie du premier enroulement magnétique (M1),
le premier enroulement magnétique (M1) générant avec le premier courant de fonctionnement (I01) un premier champ magnétique de fonctionnement (B01) dans le volume du premier enroulement magnétique (M1), (f) excitation d'un second courant de fonctionnement (102) au moins dans une partie du second enroulement magnétique (M2) au plus tard après le refroidissement de l'agencement d'aimants (M) à la température de fonctionnement (T0),
le second enroulement magnétique (M2) générant avec le second courant de fonctionnement (I02) un second champ magnétique de fonctionnement (B02) dans le volume du premier enroulement magnétique (M1).

2. Procédé selon la revendication 1, dans lequel l'agencement d'aimants (M) est amené à au moins une autre température de départ (T2) entre la première température de transition (Tc1) et la température de fonctionnement (T0) et un autre courant de départ (I2) est ensuite excité au moins dans une partie du premier enroulement magnétique (M1).

3. Procédé selon la revendication 2, dans lequel les intervalles entre les températures de départ (T1, T2) et/ou les étapes d'excitation du courant de départ sont choisis finement de manière à obtenir un processus continu de mise en température et de refroidissement de l'agencement d'aimants (M) à la température de fonctionnement (T0) et/ou une séquence continue d'étapes d'excitation du courant de départ dans le premier enroulement magnétique (M1).

4. Procédé selon l'une des revendications précédentes, dans lequel la mise en température de l'agencement d'aimants supraconducteurs (M) à la première ou à l'autre température de départ (T1, T2) est effectuée en remplissant un récipient (V) de l'agencement cryogénique avec de l'azote liquide ou en faisant fonctionner un cryorefroidisseur (CC).

5. Procédé selon l'une des revendications 1 à 3, dans lequel le refroidissement de l'agencement d'aimants supraconducteurs (M) à la température de fonctionnement (T0) est effectué en remplissant un récipient (V) de l'agencement cryogénique avec de l'hélium liquide ou en faisant fonctionner un cryorefroidisseur (CC).

6. Procédé selon l'une des revendications 2 à 5, dans lequel le premier et/ou l'autre courant de départ excité (I1, I2) et le premier courant de fonctionnement (I01) forment une suite monotone croissante dans le temps d'intensités de courant dans le premier enroulement magnétique (M1).

7. Procédé selon l'une des revendications 2 à 6, dans lequel la première et au moins l'autre température de départ (T1, T2) et la température de fonctionnement (T0) forment une suite monotone décroissante dans le temps de températures.

8. Procédé selon l'une des revendications 2 à 5, dans lequel le premier et/ou au moins l'autre courant de départ excité (I1, I2) et le premier courant de fonctionnement (I01) forment dans le premier enroulement magnétique (M1) une suite chronologique d'intensités de courant dont les valeurs diminuent vers la fin de la suite, en particulier de telle sorte que le premier courant de fonctionnement (I01) est inférieur au premier courant de départ excité (I1) et/ou inférieur à au moins l'autre courant de départ excité (I2).

9. Procédé selon l'une des revendications précédentes, dans lequel, après la charge, l'agencement d'aimants (M) fonctionne dans un état permanent avec une température de fonctionnement constante (T0) et avec des premier et second courants de fonctionnement constants (I01, I02), en particulier en tant que partie d'un agencement pour un procédé de résonance magnétique.
